# EUROPEAN PATENT APPLICATION

(11) **EP 4 752 568 A1**
(43) Date of publication of application: **03.06.2026**
(21) Application number: 24845139.5
(22) Date of filing: 02.05.2024
(51) Int. Cl.: G01R 21/133, G01R 11/02

(54) **FIRST MEASUREMENT DEVICE, SECOND MEASUREMENT DEVICE, MEASUREMENT SYSTEM, AND MEASUREMENT METHOD**

(30) Priority: 24.07.2023 JP 2023119933
(71) Applicant: Hioki E.E. Corporation, Ueda-shi, Nagano 386-1192 (JP)
(72) Inventor: KONDO, Hideharu, Ueda-shi, Nagano 386-1192 (JP); TAKEUCHI, Yoichiro, Ueda-shi, Nagano 386-1192 (JP)
(74) Representative: Novagraaf International SA
(86) International application number: PCT/JP2024/016868
(87) International publication number: WO 2025/022754

(57) **Abstract**

A first measurement device of a measurement system includes one or more input terminals, and generates a synchronization signal on the basis of a timing at which a feature point of a waveform of an input signal input to any of the input terminals is detected. The first measurement device further includes an output terminal for outputting the generated synchronization signal, and calculates a measurement amount of the input signal of the one or more input terminals at a measurement interval determined by the synchronization signal. One or more second measurement devices include one or more input terminals, include a synchronization terminal for receiving the synchronization signal output from the output terminal of the first measurement device, and calculate a measurement amount of the input signal of the one or more input terminals at the measurement interval determined by the synchronization signal.

## Description

### TECHNICAL FIELD

The present invention relates to a first measurement device, a second measurement device, a measurement system, and a measurement method, which measure an input signal.

JP2010-197223A discloses a wattmeter that synchronizes at a zero cross point in a line voltage of a channel with the lowest number when a plurality of channels set for alternating current are present.

### SUMMARY OF INVENTION

In a measurement device described above, a plurality of channels of the measurement device itself configured to be able to receive inputs can be synchronized. However, there is a problem that in order to synchronize a plurality of measurement devices with each other, the same signal needs be input to each measurement device so that a feature point such as a zero cross point is detected at the same timing in each measurement device.

The present invention has been made in view of such problems, and an object of the present invention is to synchronize a plurality of measurement devices with each other even without inputting the same signal to each of the measurement devices.

According to an aspect of the present invention, a measurement system includes a plurality of measurement devices that measure an input signal. A first measurement device among the plurality of measurement devices includes: one or more input terminals for receiving the input signal; a detection unit configured to detect a feature point of a wavelength of the input signal input to the input terminal; and a generation unit configured to generate a synchronization signal for synchronizing operations of the measurement devices on the basis of a timing at which the feature point is detected by the detection unit. The first measurement device further includes: a first calculator configured to calculate a measurement amount of the input signal input to the one or more input terminals at a measurement interval determined by the synchronization signal; and an output terminal for outputting the synchronization signal generated by the generation unit. One or more second measurement devices include: one or more input terminals for receiving the input signal; a synchronization terminal for receiving the synchronization signal output from the output terminal of the first measurement device; and a second calculator configured to calculate a measurement amount of the input signal input to the one or more input terminals at the measurement interval determined by the synchronization signal.

According to this aspect, the synchronization signal generated by the first measurement device is transmitted to the second measurement device, so that the first measurement device and the second measurement device can be synchronized with each other. Therefore, the same signal as the signal input to the detection unit of the first measurement device needs not be input to the second measurement device so that the second measurement device detects a feature point at the same timing as the timing at which a feature point is detected by the detection unit of the first measurement device.

Accordingly, a plurality of measurement devices can be synchronized with each other even without inputting the same signal to each of the measurement devices.

### BRIEF DESCRIPTION OF DRAWINGS

FIG. 1 is a diagram illustrating a basic configuration of a measurement system according to a first embodiment.
FIG. 2 is a block diagram illustrating details of a partial configuration of each of the measurement devices constituting the measurement system.
FIG. 3A is a diagram for explaining an example of a method of calculating a measurement amount of a signal input to each measurement device in accordance with a synchronization signal of the first embodiment.
FIG. 3B is a diagram for explaining a method of calculating a measurement amount of a signal input to each measurement device in accordance with a synchronization signal of a comparative example.
FIG. 4 is a flowchart showing an example of a measurement method performed by the measurement system.
FIG. 5 is a diagram illustrating a configuration of a measurement system according to a second embodiment.
FIG. 6 is a diagram illustrating a configuration of a measurement system according to a third embodiment.

### DESCRIPTION OF EMBODIMENTS

Embodiments of the present invention are described below with reference to the accompanying drawings. In the present specification, the same or equivalent elements are denoted by the same reference signs.

### First Embodiment

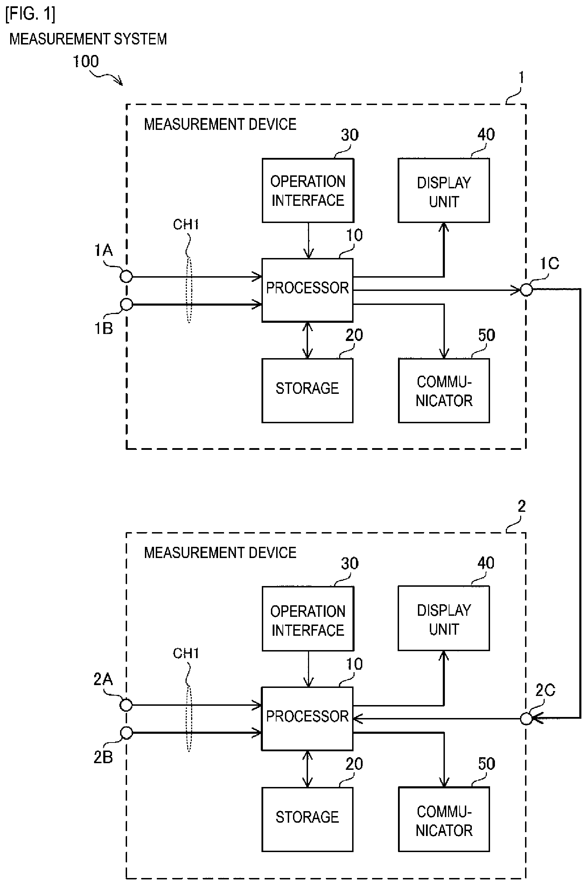

FIG. 1 is a diagram illustrating a configuration of a measurement system 100 according to a first embodiment.

The measurement system 100 is a system for measuring a plurality of measurement points, and measures, for example, input and output signals of a measurement target having one or more input ports and one or more output ports. Examples of the measurement target include a multiple-input single-output, single-input multiple-output, or multiple-input multiple-output power converter, and a repeater.

The measurement system 100 of the first embodiment measures an electrical signal transmitted to single-input single-output converter, as an example. The measurement system 100 includes a plurality of measurement devices 1 and 2. The measurement device 1 is a first measurement device that measures an input signal input to one or more channels, and the measurement device 2 is a second measurement device that measures an input signal input to one or more channels.

Each of the measurement devices 1 and 2 is a computer configured by a processor, a read only memory (ROM), a random access memory (RAM), an input/output interface, a bus connecting these components to each other, and the like.

Each of the measurement devices 1 and 2 of the first embodiment is implemented with a wattmeter that measures power input to a first channel CH1. The measurement device 1 and the measurement device 2 are connected wirelessly or by wire, and are connected via a transmission cable such as a coaxial cable or an optical cable, for example.

The measurement device 1 measures an input signal input to an input terminal portion 1A of the first channel CH1 and an input signal input to an input terminal portion 1B. The measurement device 1 outputs a synchronization signal for synchronizing measurement operations of the measurement devices 1 and 2 to an output terminal 1C.

In the first embodiment, the input terminal portion 1A has positive and negative voltage input terminals and is connected to an input terminal portion (input port) of the converter. An AC voltage signal is applied as an input signal to the input terminal portion 1A from the input terminal portion of the converter.

The input terminal portion 1B has positive and negative current input terminals and is connected to an output terminal portion (output port) of the converter. An AC current signal is supplied as an input signal to the input terminal portion 1B from the output terminal portion of the converter.

The output terminal 1C is a terminal for transmitting the synchronization signal to the measurement device 2, and is connected to a synchronization terminal 2C of the measurement device 2 via an optical cable in the first embodiment.

The measurement device 1 of the first embodiment includes a processor 10, a storage 20, an operation interface 30, a display unit 40, and a communicator 50.

In the measurement device 1, the processor 10 receives a voltage signal input to the input terminal portion 1A and a current signal input to the input terminal portion 1B, and generates a synchronization signal by using any one of the received voltage signal and current signal.

The voltage signal is a detection signal proportional to the magnitude of a voltage of the measurement target, and corresponds to, for example, an output signal of a voltage sensor, or the like. The current signal is a detection signal proportional to the amount of a current flowing through the measurement target, and corresponds to, for example, an output signal of a current sensor, or the like.

The processor 10 measures the voltage signal and the current signal on the basis of the generated synchronization signal. The processor 10 further measures power input to the first channel CH1 by using measurement amounts of the voltage signal and the current signal.

The processor 10 outputs the generated synchronization signal to the output terminal 1C. In addition to the synchronization signal, the processor 10 may also output a measurement amount of the power in the first channel CH1 to the output terminal 1C to calculate the power efficiency of the converter.

The storage 20 stores the measurement amounts of the voltage, the current, and the power in the first channel CH1 obtained by the processor 10. The storage 20 stores a program for controlling the operation of the measurement device 1. The storage 20 is a computer-readable recording medium in which the program is recorded, and is configured by a ROM and a RAM.

The operation interface 30 is configured by a plurality of push buttons provided around a display screen, a touch sensor disposed in the display screen, a keyboard, a mouse, or the like. The operation interface 30 receives an input operation of a user and generates an operation signal indicating details of the received input operation.

Examples of the input operation include an operation of pressing a power button, an operation of setting a measurement condition and a display condition, an operation of setting the type (AC or DC) of the input signal, and an operation instructing termination of the measurement process. The operation of setting the measurement condition includes an operation of setting an input terminal portion for generating a synchronization signal from the plurality of input terminal portions 1A and 1B, that is, an operation of setting a synchronization source.

The display unit 40 displays, for example, the measurement result, the measurement condition, and the like by the processor 10. The display unit 40 is configured by, for example, a touch panel so that the user can visually recognize information and operate the display unit 40. Alternatively, the display unit 40 may be configured by a liquid crystal display, an LED display, or the like.

The communicator 50 performs communication between the measurement device 1 itself and an external device or the measurement device 2 via a wired or wireless connection. For example, the communicator 50 transmits the measurement result and the measurement condition by the processor 10 to the external device. Examples of the external device include a personal computer, a portable terminal such as a smartphone and a tablet, and a measurement device separate from the measurement devices 1 and 2.

A configuration of the measurement device 2 is described below.

The measurement device 2 acquires the synchronization signal input through the output terminal 1C of the measurement device 1 from the synchronization terminal 2C of the measurement device 2. On the basis of the acquired synchronization signal, the measurement device 2 measures an input signal input to the input terminal portion 2A of the first channel CH1 and an input signal input to the input terminal portion 2B.

In the first embodiment, the input terminal portion 2A has positive and negative voltage input terminals and is connected to an output portion (output port) of the converter. An AC voltage signal is applied as an input signal to the input terminal portion 2A from the output portion of the converter.

The input terminal portion 2B has positive and negative current input terminals and is connected to the output portion of the converter. The AC current signal is supplied as an input signal to the input terminal portion 2B from the output portion of the converter.

Moreover, the synchronization terminal 2C is a terminal for receiving the synchronization signal from the measurement device 1, and is connected to the output terminal 1C of the measurement device 1 via an optical cable.

Similarly to the measurement device 1, the measurement device 2 of the first embodiment includes a processor 10, a storage 20, an operation interface 30, a display unit 40, and a communicator 50.

In addition to the above-described functions, the processor 10 acquires the synchronization signal input from the measurement device 1 to the synchronization terminal 2C. On the basis of the acquired synchronization signal, the processor 10 measures a voltage signal input to the input terminal portion 2A and a current signal input to the input terminal portion 2B. The processor 10 measures power input to the first channel CH1 by using the measurement amounts of the voltage signal and the current signal.

Moreover, the processor 10 acquires the measurement amount of the measured power as a second power value, and acquires, as a first power value, the measurement amount of the input power in the first channel CH1 of the measurement device 1 from the output terminal 1C. Subsequently, the processor 10 calculates the power efficiency of the converter by dividing the second power value by the first power value.

Since the storage 20, the operation interface 30, the display unit 40, and the communicator 50 have the same configurations as those of the measurement device 1, descriptions thereof are omitted here.

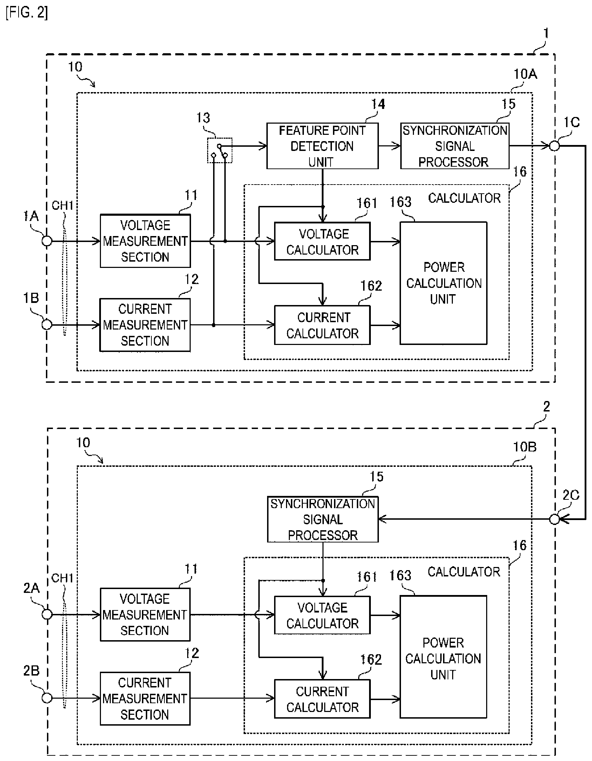

A detailed configuration of each of the measurement devices 1 and 2 is described below with reference to FIG. 2.

FIG. 2 is a block diagram illustrating a main functional configuration of each of the measurement devices 1 and 2 according to the first embodiment. In FIG. 2, for convenience, the storage 20, the operation interface 30, and the display unit 40 are omitted, and the functional configuration of the processor 10 of each of the measurement devices 1 and 2 is illustrated.

A processor 10A of the measurement device 1 and a processor 10B of the measurement device 2 each implement a part of the functions of the processor 10 illustrated in FIG. 1.

First, the processor 10A of the measurement device 1 is described. The processor 10A includes a voltage measurement section 11, a current measurement section 12, a switch 13, a feature point detection unit 14, a synchronization signal processor 15, and a calculator 16. The calculator 16 includes a voltage calculator 161, a current calculator 162, and a power calculation unit 163.

The voltage measurement section 11 measures a level of a voltage signal input to the input terminal portion 1A. The voltage measurement section 11 of the first embodiment is a circuit that converts the voltage signal to a signal level within a predetermined measurement range. The voltage measurement section 11 is configured by an amplifier that amplifies an input signal and an A/D converter that converts an output signal of the amplifier into a digital signal.

The current measurement section 12 measures a level of a current signal input to the input terminal portion 1B. The current measurement section 12 of the first embodiment is a circuit that converts the current signal to a signal level within a predetermined measurement range. The current measurement section 12 is configured by an amplifier that amplifies an input signal and an A/D converter that converts an output signal of the amplifier into a digital signal.

The switch 13 is a signal selector that selects one waveform signal used for generating a synchronization signal. The switch 13 outputs an AC signal designated by the operation interface 30 illustrated in FIG. 1, out of the signal output from the voltage measurement section 11 and used as the voltage signal input to the input terminal portion 1A and the signal output from the current measurement section 12 and used as the current signal input to the input terminal portion 1B.

The switch 13 of the first embodiment outputs the output signal of the voltage measurement section 11 to the feature point detection unit 14 according to an operation signal from the operation interface 30. That is, the switch 13 selects any one input signal as a synchronization source from a plurality of input signals input to the measurement device 1.

The feature point detection unit 14 functions as a detection unit that detects a feature point of a waveform indicated by the input signal. Examples of the feature point of the waveform include a zero cross point of an AC waveform, a point indicating a maximum value or a minimum value of the waveform, and a point indicating an average value or an effective value of the waveform.

The feature point detection unit 14 of the first embodiment is configured by a zero cross point detection circuit as an example. The feature point detection unit 14 detects a zero cross point of the voltage signal output from the switch 13.

The feature point detection unit 14 also functions as a generation unit that generates a synchronization signal for synchronizing the measurement operations of the measurement devices 1 and 2 on the basis of the timing at which the above feature point is detected. As the generated synchronization signal, for example, a pulse signal is used. The feature point detection unit 14 outputs the generated synchronization signal to the synchronization signal processor 15.

When the synchronization signal processor 15 acquires the synchronization signal generated by the feature point detection unit 14, the synchronization signal processor 15 transmits the synchronization signal from the output terminal 1C to the measurement device 2 via an optical cable. When information is present to be shared in order to improve the accuracy of power calculation or high-frequency calculation, the synchronization signal processor 15 may transmit the synchronization signal including a pulse signal with the information to be shared.

In addition, the synchronization signal processor 15 can transmit the measurement result obtained by the calculator 16 in addition to the synchronization signal, or receive the measurement result of the measurement device 2. In this way, the synchronization signal processor 15 has a function of communicating with the synchronization signal processor 15 of the measurement device 2 by using any protocol.

When communication is performed between the synchronization signal processors 15 of the measurement devices 1 and 2, for example, a communication method in which the measurement device 1 accesses a specific memory area of the measurement device 2 is adopted. In the first embodiment, the synchronization signal processor 15 of the measurement device 1 notifies a specific memory area in the synchronization signal processor 15 of the measurement device 2 of the zero cross point via write access.

Moreover, the synchronization signal processor 15 supplies the synchronization signal generated by the feature point detection unit 14 to each of the voltage calculator 161 and the current calculator 162.

The calculator 16 functions as a first calculator that calculates a measurement amount of the input signal input to at least one of the input terminal portions 1A and 1B at a measurement interval determined by the synchronization signal. Examples of the measurement amount include a voltage value, a current value, and a power value.

The voltage calculator 161 determines measurement intervals according to the synchronization signal supplied from the synchronization signal processor 15, and sequentially calculates the voltage value of the voltage signal input to the input terminal portion 1A at each measurement interval. Examples of the voltage value to be calculated include an average value and an effective value.

In the first embodiment, the voltage calculator 161 calculates the effective value of the voltage signal according to the measurement interval determined by the synchronization signal from the synchronization signal processor 15. The voltage calculator 161 outputs the calculated effective value of the voltage signal to the power calculation unit 163 as a measurement amount.

Similarly to the voltage calculator 161, the current calculator 162 determines measurement intervals according to the synchronization signal, and sequentially calculates the current value of the current signal input to the input terminal portion 1B at each measurement interval. Examples of the current value to be calculated include an average value and an effective value.

In the first embodiment, the current calculator 162 calculates the effective value of the current signal according to the measurement interval determined by the synchronization signal. The current calculator 162 outputs the calculated effective value of the current signal to the power calculation unit 163 as a measurement amount.

The power calculation unit 163 calculates the first power value of the power input to the first channel CH1 by multiplying the effective value of the voltage signal output from the voltage calculator 161 by the effective value of the current signal output from the current calculator 162.

A configuration example of the processor 10B of the measurement device 2 is described below. In this example, a signal input to the synchronization terminal 2C is selected as the synchronization signal of the measurement device 2 by the operation interface 30 of the measurement device 2, and accordingly, the functions of the switch 13 and the feature point detection unit 14 are disabled.

Similarly to the processor 10A, the processor 10B includes a voltage measurement section 11, a current measurement section 12, a synchronization signal processor 15, and a calculator 16. The calculator 16 includes a voltage calculator 161, a current calculator 162, and a power calculation unit 163.

In addition to the above-described functions, the synchronization signal processor 15 receives, from the synchronization terminal 2C, the synchronization signal transmitted from the measurement device 1 according to an operation signal from the operation interface 30 of the measurement device 2. The synchronization signal processor 15 supplies the received synchronization signal to each of the voltage calculator 161 and the current calculator 162.

The calculator 16 functions as a second calculator that calculates a measurement amount of the input signal input to at least one of the input terminal portions 2A and 2B at a measurement interval determined by the synchronization signal from the synchronization terminal 2C. Examples of the measurement amount include a voltage value, a current value, and a power value.

Since the voltage calculator 161, the current calculator 162, and the power calculation unit 163 have the same configurations as those of the measurement device 1, redundant descriptions thereof are omitted here.

Similarly to the measurement device 1, the power calculation unit 163 calculates the second power value of the power input to the first channel CH1 by multiplying the effective value of the voltage signal output from the voltage calculator 161 by the effective value of the current signal output from the current calculator 162.

When the second power value is calculated, the power calculation unit 163 may acquire the first power value of the power input to the first channel CH1 in the measurement device 1 from the synchronization signal processor 15, and calculate power efficiency by dividing the second power value by the first power value.

At this time, in the measurement device 1, the synchronization signal processor 15 acquires the first power value from the power calculation unit 163, and transmits the first power value to the measurement device 2 together with the synchronization signal. In the measurement device 2, the synchronization signal processor 15 outputs the first power value received together with the synchronization signal to the power calculation unit 163.

Although the power calculation unit 163 of the measurement device 2 calculates the power efficiency of the converter to be measured, the power calculation unit 163 of the measurement device 1 may calculate the power efficiency of the converter instead. In this case, the first power value is transmitted from the synchronization signal processor 15 of the measurement device 2 to the synchronization signal processor 15 of the measurement device 1.

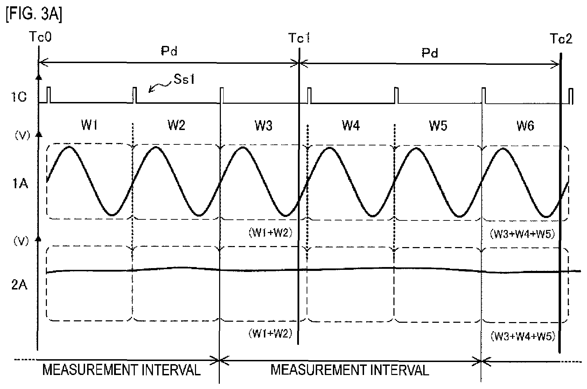

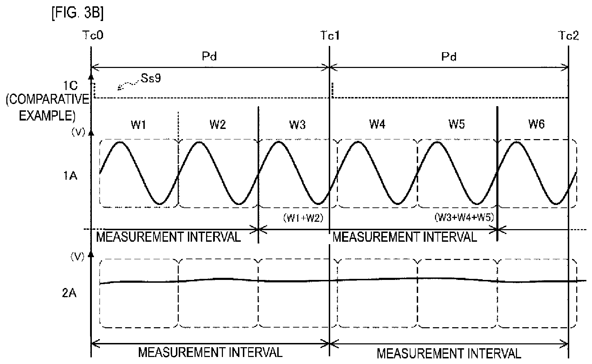

The synchronization process performed by the measurement devices 1 and 2 in the present embodiment is described below with reference to FIGS. 3A and 3B.

FIG. 3A is a time chart for explaining an example of a method of calculating a measurement amount on the basis of a synchronization signal Ss1 of the first embodiment generated by the feature point detection unit 14. FIG. 3B is a time chart for explaining a method of calculating a measurement amount on the basis of a synchronization signal Ss9 generated independently of an input signal as a comparative example.

FIGS. 3A and 3B illustrate signal processing in a state in which the input terminal portion of the converter to be measured is connected to the input terminal portion 1A of the measurement device 1 and the output terminal portion of the converter is connected to the input terminal portion 2A of the measurement device 2.

FIGS. 3A and 3B illustrate an AC waveform of a voltage signal input to the input terminal portion 1A of the measurement device 1 and a DC waveform of a voltage signal input to the input terminal portion 2A of the measurement device 2, respectively. In FIGS. 3A and 3B, for each voltage signal, a vertical axis represents the magnitude of a voltage and a horizontal axis represents the passage of time. For convenience, an example in which a voltage signal is input to each of the input terminal portions 1A and 2A immediately after a calculation timing Tc0 is described.

FIG. 3A illustrates the synchronization signal Ss1 transmitted from the output terminal 1C of the measurement device 1 to the synchronization terminal 2C of the measurement device 2. The synchronization signal Ss1 is a pulse signal whose pulse is formed at the timing at which the zero cross point of the voltage signal input to the input terminal portion 1A is detected by the synchronization signal processor 15.

In addition, an update cycle Pd between calculation timings Tc0 and Tc1 for calculating the measurement amount and between calculation timings Tc1 and Tc2 is a cycle for updating the measurement amount of the input signal, and is set to, for example, 50 ms. In addition, a measurement interval indicating a calculation section is a section from a zero cross point immediately before the previous calculation timing Tc0 to a zero cross point immediately before the current calculation timing Tc1.

As illustrated in FIG. 3A, the voltage values of the voltage signals input to the input terminal portions 1A and 2A are calculated by the voltage calculators 161 of both the measurement devices 1 and 2, respectively, according to the synchronization signal Ss1 output to the output terminal 1C of the measurement device 1.

Specifically, each voltage calculator 161 calculates, for example, an effective value as a voltage value for each of the waveforms W1 to W6 for one cycle with respect to the input voltage signal, and performs a statistical process on a plurality of calculated effective values at each of the calculation timings Tc0 to Tc2 to calculate a measurement amount. The measurement amount referred to here may be a representative value such as an average value or a median value of the plurality of effective values.

Similarly, the measurement amount of the current signal input to the input terminal portion 1B of the measurement device 1 and the measurement amount of the current signal input to the input terminal portion 2B of the measurement device 2 are calculated according to the synchronization signal Ss1. Subsequently, a power value is calculated by the power calculation unit 163 of the measurement device 1 by using the measurement amounts of the input terminal portions 1A and 1B, and a power value is calculated by the power calculation unit 163 of the measurement device 2 by using the measurement amounts of the input terminal portions 2A and 2B.

At the calculation timing Tc1, the measurement amounts of the two waveforms W1 and W2 within the measurement interval determined by the synchronization signal Ss1 are calculated, and at the calculation timing Tc2, the measurement amounts of the three waveforms W3 to W5 within the measurement interval determined by the synchronization signal Ss1 are calculated.

In this way, by performing power calculation of the input signals input to the different measurement devices 1 and 2 according to one synchronization signal Ss1, the power calculation is performed with calculation sections of both inputs and outputs of measurement targets aligned, so that power efficiency of the measurement targets can be accurately obtained.

On the other hand, in FIG. 3B, the synchronization signal Ss9 is generated independently of the input signal. Therefore, since no zero cross point is detected in the waveform of the voltage signal input to the input terminal portion 2A, the section between the previous calculation timings Tc0 and Tc1, that is, the update cycle Pd itself, is the measurement interval.

As a result, the measurement interval of the voltage signal input to the input terminal portion 1A of the measurement device 1 and the measurement interval of the voltage signal input to the input terminal portion 2A of the measurement device 2 are shifted from each other. In this way, since power efficiency is obtained using two power values calculated at different measurement intervals, the measurement accuracy of the power efficiency is reduced.

On the other hand, in the first embodiment, since the measurement interval is determined using the synchronization signal Ss1 in both the measurement devices 1 and 2, errors in the measurement amount can be reduced as compared with the case of using the synchronization signal Ss9 of the comparative example.

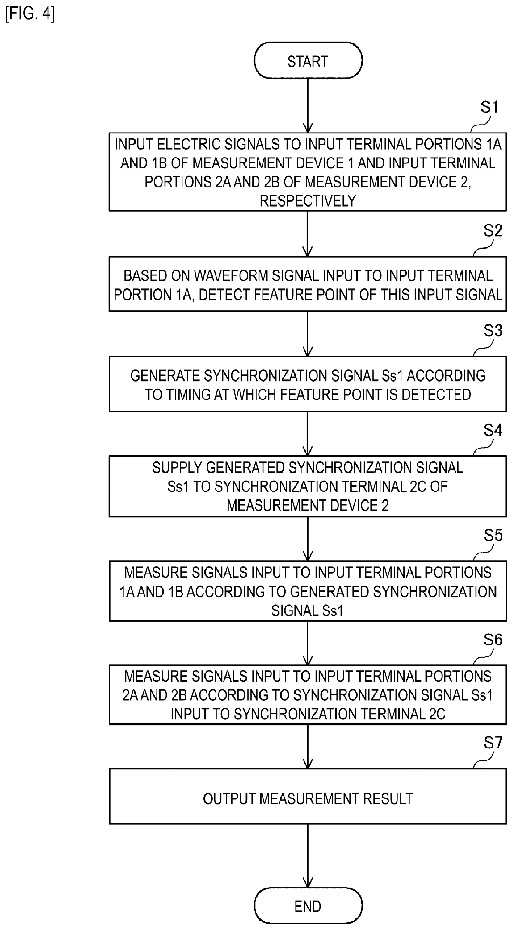

The operation of the measurement system 100 according to the first embodiment is described below with reference to FIG. 4.

FIG. 4 is a flowchart showing an example of a processing procedure of a measurement method performed by the measurement system 100.

In this example, the input terminal portion 1A of the measurement device 1 is connected to the input terminal portion of the converter to be measured, and the input terminal portion 2A of the measurement device 2 is connected to the output terminal portion of the converter.

The input terminal portion 1B of the measurement device 1 is connected to an output terminal portion of a current sensor that detects a current flowing through a power cable connected to the positive electrode terminal of the input terminal portion 1A. In addition, the input terminal portion 2B is connected to an output terminal portion of a current sensor that detects a current flowing through a power cable connected to the positive electrode terminal of the input terminal portion 2A. As the current sensor, for example, a sensor that clamps the power cable and detects a current flowing through the power cable in a non-contact manner is used.

In step S1, a voltage signal generated between the positive and negative electrode terminals constituting the input terminal portion of the converter is input to the input terminal portion 1A of the measurement device 1, and a current signal flowing through the input terminal portion of the converter is input to the input terminal portion 1B. Moreover, a voltage signal generated between the positive and negative electrode terminals constituting the output terminal portion of the converter is input to the input terminal portion 2A of the measurement device 2, and a current signal flowing through the output terminal portion of the converter is input to the input terminal portion 2B.

In step S2, the measurement device 1 detects the feature point of a waveform of the input signal on the basis of the waveform signal input to the input terminal portion 1A. The waveform signal includes, for example, an AC signal that oscillates with zero as a reference, a signal in which an AC signal is superimposed on a DC signal, and the like.

Specifically, the measurement device 1 according to the first embodiment detects a zero cross point of the waveform of the AC signal by using the AC signal input to the input terminal portion 1A.

In step S3, the measurement device 1 generates the synchronization signal Ss1 according to the timing at which the feature point is detected.

The processes of steps S2 and S3 described above correspond to a generation step of generating the synchronization signal Ss1 for synchronizing the operations of the measurement devices 1 and 2 on the basis of the timing at which the feature point of the waveform of the input signal input to the measurement device 1 is detected.

In step S4, the measurement device 1 supplies the generated synchronization signal Ss1 to the synchronization terminal 2C of the measurement device 2 through the output terminal 1C. The process of step S4 corresponds to an output step of outputting the synchronization signal Ss1.

In step S5, the measurement device 1 measures signals input to the input terminal portions 1A and 1B according to the generated synchronization signal Ss1.

Specifically, the measurement device 1 according to the first embodiment calculates the measurement amount of the voltage signal input to the input terminal portion 1A and the measurement amount of the current signal input to the input terminal portion 1B, in accordance with the synchronization signal Ss1. Moreover, the measurement device 1 calculates a first power value as a new measurement amount by using the measurement amounts of the voltage signal and the current signal.

That is, the process of step S5 corresponds to a first calculation step of calculating the measurement amount of one or more input signals input to the measurement device 1 at a measurement interval determined by the synchronization signal Ss1.

In step S6, the measurement device 2 receives the synchronization signal Ss1 supplied from the measurement device 1 to the synchronization terminal 2C, and measures the signals input to the input terminal portions 2A and 2B according to the synchronization signal Ss1.

The process of step S6 corresponds to a reception step of receiving the synchronization signal Ss1 output from the measurement device 1 to at least one measurement device 2, and a second calculation step of calculating the measurement amount of one or more input signals input to at least one measurement device 2 at the measurement interval determined by the synchronization signal Ss1.

Specifically, the measurement device 2 according to the first embodiment calculates the measurement amount of the voltage signal input to the input terminal portion 2A and the measurement amount of the current signal input to the input terminal portion 2B, in accordance with the synchronization signal Ss1. Moreover, the measurement device 2 calculates a second power value as a new measurement amount by using the measurement amounts of the voltage signal and the current signal.

In step S7, the measurement devices 1 and 2 output measurement results, respectively. Examples of the measurement result include a voltage value, a current value, a power value, and the power efficiency of the second power value with respect to the first power value.

For example, the measurement device 1 according to the first embodiment displays the voltage values and the current values of the input terminal portions 1A and 1B, the first power value, or the power efficiency, records the values in an external or internal memory, or transmits the values to an external device. The measurement device 2 also outputs the measurement result in the same manner.

When the process of step S7 is completed, the series of processes for the measurement method according to the first embodiment ends.

Operations and effects of the first embodiment are described below.

In the first embodiment, the measurement system 100 includes the plurality of measurement devices 1 and 2 that measure input signals. The measurement device 1 is a first measurement device, and the measurement device 2 is a second measurement device.

The measurement device 1 includes the input terminal portions 1A and 2B each configured by one or more input terminals for receiving an input signal. The measurement device 1 further includes the feature point detection unit 14 that functions as a detection unit for detecting the feature point of a waveform of the input signal input to one input terminal portion 1A, and the feature point detection unit 14 also functions as a generation unit for generating the synchronization signal Ss1 for synchronizing the operations of the measurement devices 1 and 2 on the basis of a timing at which the feature point is detected.

The measurement device 1 includes the calculator 16 as a first calculator that calculates the measurement amount of the input signal input to the one or more input terminals at the measurement interval determined by the synchronization signal Ss1. The measurement device 1 further includes the output terminal 1C for outputting the synchronization signal Ss1 generated by the feature point detection unit 14.

The measurement device 2 includes the input terminal portions 2A and 2B configured by one or more input terminals for receiving an input signal, and the synchronization terminal 2C for receiving the synchronization signal Ss1 output from the output terminal 1C of the measurement device 1. The measurement device 2 further includes the calculator 16 as a second calculator that calculates the measurement amount of the input signal input to the one or more input terminals at the measurement interval determined by the synchronization signal Ss1.

The measurement method according to the first embodiment is performed by the plurality of measurement devices 1 and 2 that measure one or more input signals. The measurement method includes the generation steps S2 and S3 of generating the synchronization signal Ss1 for synchronizing the operations of the measurement devices 1 and 2 on the basis of a timing at which the feature point of a waveform of one input signal input to the measurement device 1 is detected.

The measurement method further includes the first calculation step S5 of calculating a measurement amount of one or more input signals input to the measurement device 1 at the measurement interval determined by the synchronization signal Ss1, and the output step S4 of outputting the synchronization signal Ss1.

The measurement method includes the reception step of receiving the synchronization signal Ss1 output from the measurement device 1 to at least one measurement device 2, and the second calculation step of calculating a measurement amount of one or more input signals input to at least one measurement device 2 at the measurement interval determined by the synchronization signal Ss1.

According to the configuration of the measurement system 100 and the measurement method described above, since the synchronization signal Ss1 generated by the measurement device 1 is transmitted to the measurement device 2, the measurement device 1 and the measurement device 2 can be synchronized with each other. Therefore, the same signal as the synchronization source input to the feature point detection unit 14 of the measurement device 1 needs not be input to the measurement device 2 so that the feature point is detected in the measurement device 2 at the same timing as the timing at which the feature point is detected by the feature point detection unit 14 of the measurement device 1.

Accordingly, the plurality of measurement devices 1 and 2 can be synchronized with each other without inputting the same signal to each of the measurement devices 1 and 2.

In the first embodiment, the input signal is a voltage signal or a current signal, and the measurement amount is an effective value or an average value of the voltage signal or the current signal.

According to this configuration, a plurality of measurement amounts of a measurement target to/from which the voltage signal or the current signal is input or output can be accurately calculated with a measurement interval aligned.

In the first embodiment, the input terminal portions 1A and 1B configured by a plurality of input terminals are provided in the measurement device 1, and the input terminal portions 2A and 2B configured by a plurality of input terminals are provided in the measurement device 2. The input terminal portions 1A and 2A are configured by voltage input terminals for receiving voltage signals, and the input terminal portions 1B and 2B are configured by current input terminals for receiving current signals.

Subsequently, at the same measurement interval, the voltage calculator 161 of each calculator 16 of the measurement devices 1 and 2 calculates the voltage value of the voltage signal as the measurement amount, and the current calculator 162 of each calculator 16 calculates the current value of the current signal as the measurement amount. At this time, the voltage calculator 161 and the current calculator 162 of the measurement device 1 function as a first calculator, and the voltage calculator 161 and the current calculator 162 of the measurement device 2 function as a second calculator.

According to this configuration, all the measurement amounts of the voltage value and the current value are calculated at the same timing and at the same measurement interval, so that the state of a load of a measurement target can be accurately estimated by comparing or calculating each of the measurement amounts. For example, all the measurement amounts are calculated at the same measurement interval, so that the numerical value of power or power efficiency of the measurement target can be accurately estimated.

In the first embodiment, the power calculation unit 163 of the measurement device 1 functions as a first calculator, and the power calculation unit 163 of the measurement device 2 functions as a second calculator. Each of the power calculation units 163 calculates a power value on the basis of calculated voltage value and current value.

According to this configuration, when the measurement device 1 measures input power of a measurement target and the measurement device 2 measures output power of the same measurement target, the relationship between the input and the output of the measurement target can be accurately ascertained.

In the first embodiment, the power calculation unit 163 of the measurement device 1 calculates a first power value on the basis of calculated voltage value and current value, and the power calculation unit 163 of the measurement device 2 calculates a second power value on the basis of calculated voltage value and current value. Subsequently, any one of the power calculation units 163 calculates power efficiency on the basis of the first power value and the second power value.

According to this configuration, all the measurement amounts used for calculating the power value are calculated at the same measurement interval, so that a measurement error of the power efficiency can be reduced.

In addition, in the first embodiment, one of the first power value and the second power value is the input power of a power conversion device, and the other thereof is the output power of the power conversion device.

According to this configuration, since a measurement target is the power conversion device, the power efficiency of the power conversion device can be accurately measured.

In addition, in the first embodiment, the measurement device 1 is connected to the measurement device 2 that calculates the measurement amounts of input signals input to the input terminal portions 2A and 2B at a measurement interval determined by the synchronization signal Ss1.

As described above, the measurement device 1 includes the input terminal portions 1A and 1B, the feature point detection unit 14 as a detection unit and a generation unit, the calculator 16 as a first calculator, and the output terminal 1C.

According to this configuration, the measurement device 1 supplies the synchronization signal Ss1 generated by itself to the measurement device 2. This enables the measurement device 2 to calculate the measurement amount at the measurement interval determined by the synchronization signal Ss1 generated by the measurement device 1. This enables the plurality of measurement devices 1 and 2 to be synchronized with each other without inputting the same signal to each of the measurement devices 1 and 2.

In addition, in the first embodiment, the measurement device 2 is connected to the measurement device 1 including the calculator 16 as a first calculator. The measurement device 1 detects the feature point of a waveform of an input signal input to the input terminal portion 1A, and generates the synchronization signal Ss1 on the basis of the detected timing.

As described above, the measurement device 2 includes the input terminal portions 2A and 2B, the synchronization terminal 2C, and the calculator 16 as a second calculator.

According to this configuration, the measurement device 2 calculates the measurement amounts of input signals input to the input terminal portions 2A and 2B on the basis of the synchronization signal Ss1 generated by the measurement device 1. Thus, the plurality of measurement devices 1 and 2 can be synchronized with each other without inputting the same signal to each of the measurement devices 1 and 2.

### Second Embodiment

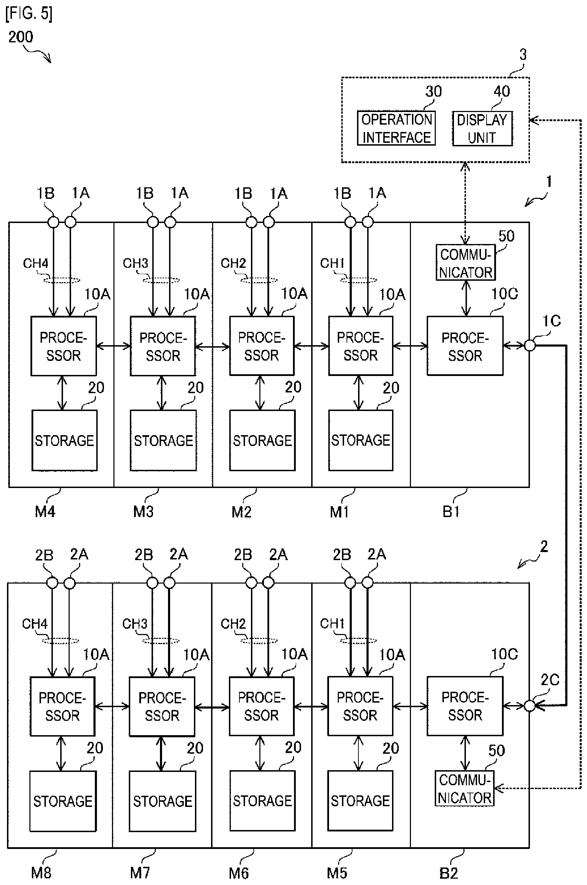

A measurement system according to a second embodiment is described below with reference to FIG. 5. In the second embodiment, the same or equivalent components as those in the first embodiment are denoted by the same reference signs and redundant descriptions thereof are omitted.

FIG. 5 is a block diagram illustrating a configuration of a measurement system 200 according to the second embodiment. The measurement system 200 includes measurement devices 1 and 2 and an external device 3.

The external device 3 includes an operation interface 30 that receives an input operation of a user and a display unit 40, and is connected to the measurement device 1 or 2 via a wired or wireless connection. The external device 3 controls the operations of the measurement devices 1 and 2 according to the input operation received by the operation interface 30.

Unlike the first embodiment, each of the measurement devices 1 and 2 according to the second embodiment is configured to be able to measure the power of four channels CH1 to CH4.

In the second embodiment, a measurement target of the measurement system 200 is a single-input multiple-output power conversion device that converts DC power into AC power. Input terminal portions of the power conversion device are connected to one channel CH1 of the measurement device 1, and seven output terminal portions of the power conversion device are connected to three channels CH2 to CH4 of the measurement device 1 and four channels CH1 to CH4 of the measurement device 2, respectively.

Since the measurement devices 1 and 2 of the second embodiment have the same configuration, the configuration of the measurement device 1 is described in detail first.

The measurement device 1 includes four modules M1 to M4 and a main body B1.

The modules M1 to M4 have the same configuration, and have a partial configuration of the measurement device 1 of the first embodiment. The modules M1 and M4 are implemented with, for example, a fieldprogrammable gate array (FPGA).

In the second embodiment, each of the modules M1 to M4 includes input terminal portions 1A and 1B, a processor 10A, and a storage 20. The processor 10A has the same configuration as that illustrated in FIG. 2.

The main body B1 performs transmission/reception processing and display processing of measurement amounts and synchronization signals Ss1 output from the respective processors 10A of the modules M1 to M4 according to operation signals indicating input operations of users from the external device 3. In the second embodiment, the main body B1 includes a processor 10C and a communicator 50 configured to be able to communicate with the external device 3.

In an operation interface 30 of the external device 3, a user selects a channel for generating the synchronization signal Ss1 from the channels CH1 to CH4 of the measurement device 1, and selects one of the input terminal portions 1A and 1B of the selected channel. Thus, the operation interface 30 generates a terminal selection signal indicating the input terminal portion of the selected channel as an operation signal. Subsequently, the external device 3 transmits the terminal selection signal to the processor 10C via the communicator 50.

The operation interface 30 generates a communication instruction signal instructing transmission of the synchronization signal Ss1 to the measurement device 2 as an operation signal according to details of the received input operation. Subsequently, the external device 3 transmits the communication instruction signal to the processor 10C via the communicator 50.

First, when the processor 10C acquires the terminal selection signal from the operation interface 30, the processor 10C instructs a processor corresponding to a channel indicated by the terminal selection signal among the processors 10A to set a connection destination of a switch 13 to an input terminal portion indicated by the terminal selection signal. At this time, processors corresponding to the other channels stop generating synchronization signals. Thus, the processor 10C acquires the synchronization signal Ss1 only from the processor, and supplies the acquired synchronization signal Ss1 to the other processors.

Each processor 10A includes a calculator 16 as a first calculator that calculates measurement amounts of input signals input to the input terminal portions 1A and 1B at a measurement interval determined by the synchronization signal Ss1. Examples of the measurement amount include a voltage value, a current value, and a power value. Each processor 10A outputs a calculated power value to the processor 10C as a first power value.

The processor 10C may calculate power efficiencies that are ratios of the first power values of the other channels CH2 to CH4 to the first power value of the first channel CH1. At this time, the processor 10C functions as a first calculator that calculates power efficiencies on the basis of the first power value and the other first power value as a second power value.

In addition, when the processor 10C acquires the communication instruction signal from the operation interface 30, the processor 10C establishes communication between the measurement device 1 and the measurement device 2 according to the communication instruction signal, and transmits the synchronization signal Ss1 to the measurement device 2 via an output terminal 1C.

When the processor 10C acquires information indicating the power value or the power efficiency of each of the channels CH1 to CH4, the processor 10C transmits the acquired information to the external device 3 through the communicator 50. A display unit 40 of the external device 3 displays the power value or the power efficiency of each of the channels CH1 to CH4 acquired by the processor 10C. The display unit 40 may display the waveform of the synchronization signal Ss1 together with the waveform of the current value, the voltage value, or the power value.

A configuration of the measurement device 2 is described below.

The measurement device 2 includes four modules M5 to M8 and a main body B2. These components have the same configurations as the modules M1 to M4 and the main body B1 of the measurement device 1.

In the measurement device 2, each of the modules M5 to M8 includes input terminal portions 2A and 2B, a processor 10A, and a storage 20, and the main body unit B1 includes a processor 10C and a communicator 50.

The operation interface 30 of the external device 3 generates a stopping signal for stopping generation of a synchronization signal as an operation signal with respect to the processor 10A of each of the modules M5 to the M8 according to a received input operation. Subsequently, the external device 3 transmits the stopping signal to the processor 10C via the communicator 50.

The external device 3 may transmit the stopping signal to the processor 10C of the measurement device 1, and the processor 10C of the measurement device 1 may transfer the received stopping signal to the processor 10C of the measurement device 2 via the output terminal 1C.

The processor 10C instructs the processor 10A of each of the modules M5 to M8 to stop the generation of the synchronization signal by controlling the connection of the switch 13 according to the generated stopping signal. When the processor 10C receives the synchronization signal Ss1 from the measurement device 1 via a synchronization terminal 2C, the processor 10C supplies the synchronization signal Ss1 to each processor 10A.

Thus, as illustrated in FIG. 3A, each processor 10A calculates the voltage value, the current value, and the power value of an input signal input to each of the channels CH1 to CH4 as a measurement amount in accordance with the synchronization signal Ss1 generated by the measurement device 1.

That is, as illustrated in FIG. 2, each processor 10A of the measurement device 2 includes a calculator 16 as a second calculator that calculates the measurement amounts of the input signals input to the input terminal portions 2A and 2B at the measurement interval determined by the synchronization signal Ss1. Subsequently, each processor 10A outputs the power value of each of the channels CH1 to CH4 to the processor 10C.

The processor 10C may acquire the power value of each of the channels CH1 to CH4 of the measurement device 2 as a second power value, and acquire the power value of the first channel CH1 of the measurement device 1 from the output terminal 1C of the measurement device 1 as a first power value. Subsequently, the processor 10C of the measurement device 2 may calculate the power efficiency of the second power value of each of the channels CH1 to CH4 of the measurement device 2 with respect to the first power value of the first channel CH1 of the measurement device 1.

Alternatively, the processor 10C of the measurement device 2 may transmit the power value of each of the channels CH1 to CH4 of the measurement device 2 to the processor 10C of the measurement device 1 as the second power value. Subsequently, the processor 10C of the measurement device 1 may calculate the power efficiency of the second power value of each of the channels CH1 to CH4 of the measurement device 2 with respect to the power value of the first channel CH1 of the measurement device 1.

At this time, the processor 10C of the measurement device 1 or 2 functions as a second calculator that calculates the power efficiency on the basis of the first power value and the second power value. When the processor 10C acquires information indicating the power value or the power efficiency of each of the channels CH1 to CH4, the processor 10C transmits the acquired information to the external device 3 through the communicator 50.

The display unit 40 of the external device displays the numerical value of the power or the power efficiency of each of the channels CH1 to CH4 acquired by the processor 10C. The display unit 40 may display the waveform of the synchronization signal Ss1 together with the waveform of the current value, the voltage value, or the power value.

Operation and effects of the second embodiment are described below.

The measurement system 200 of the second embodiment has the same or equivalent configuration as the measurement system 100 of the first embodiment and can exhibit operation and effects similar to those of the first embodiment.

For example, each processor 10A of the measurement device 1 functions as a first calculator that calculates a first power value on the basis of calculated voltage value and current value. Moreover, each processor 10A of the measurement device 2 functions as a second calculator that calculates a second power value on the basis of calculated voltage value and current value. The processor 10C of the measurement device 1 or 2 functions as a first calculator or a second calculator that calculates power efficiency on the basis of the first power value and the second power value.

According to this configuration, all the measurement amounts used for calculating the power value are calculated at the same timing and at the same measurement interval, so that a measurement error of the power efficiency can be reduced.

In the second embodiment, the first power value of the first channel CH1 of the measurement device 1 is the amount of power input to the power conversion device. The first power values of the other channels CH2 to CH4 of the measurement device 1 and the second power values of the channels CH1 to CH4 of the measurement device 2 are the amounts of a plurality of output powers from the power conversion device.

According to this configuration, the power efficiency of each input/output of the power conversion device can be accurately measured. In the second embodiment, the single-input multiple-output power conversion device has been described as an example of a measurement target; however, the present invention is not limited thereto. For example, the measurement system 200 can also measure input signals from a multiple-input single-output or multiple-input multiple-output power conversion device. The measurement system 200 can also perform a measurement on a conversion device such as an AC-DC converter and a DC-DC converter.

### Third Embodiment

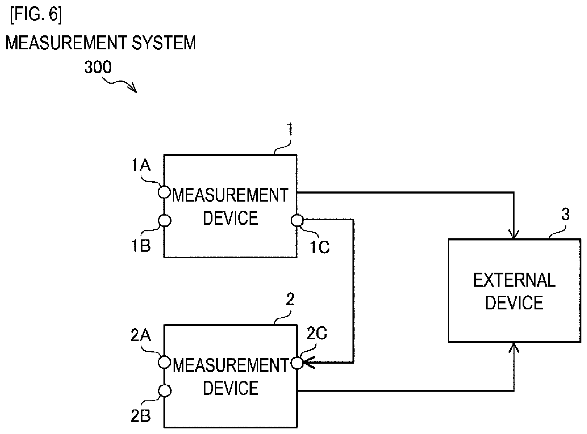

A measurement system according to a third embodiment is described below with reference to FIG. 6. The third embodiment is different from the first embodiment in that an external device calculates a power value and power efficiency of a measurement target.

FIG. 6 is a diagram illustrating a configuration of a measurement system 300 according to the third embodiment. In the following, the same or equivalent components as those in the first embodiment are denoted by the same reference signs and redundant descriptions thereof are omitted.

The measurement system 300 includes measurement devices 1 and 2, and an external device 3 that communicates with each of the measurement devices 1 and 2. In the third embodiment, a measurement target of the measurement system 300 is a single-input single-output power conversion device that converts DC power into AC power. An input terminal portion of the power conversion device is connected to a first channel CH1 of the measurement device 1, and an output terminal portion of the power conversion device is connected to a first channel CH1 of the measurement device 2.

In the measurement device 1, as in the first embodiment, a processor 10A calculates voltage values and current values of input signals input to input terminal portions 1A and 1B according to a synchronization signal Ss1 generated by the feature point detection unit 14 illustrated in FIG. 2. Similarly, also in the measurement device 2, when a processor 10B receives the synchronization signal Ss1 input to a synchronization terminal 2C from an output terminal 1C of the measurement device 1, the processor 10B calculates voltage values and current values of input signals input to input terminal portions 2A and 2B according to the synchronization signal Ss1.

Subsequently, the measurement device 1 transmits the voltage value and the current value calculated by the processor 10A to the external device 3 via a communicator 50 of the measurement device 1. Similarly, the measurement device 2 also transmits the voltage value and the current value calculated by the processor 10B to the external device 3 through a communicator 50 of the measurement device 2.

The external device 3 has the function of the power calculation unit 163 illustrated in FIG. 2. The external device 3 is configured by, for example, a personal computer, a portable terminal such as a smartphone or a tablet, or a measurement device separate from the measurement devices 1 and 2.

When the external device 3 receives the voltage values and the current values of the input signals input to the input terminal portions 1A and 1B from the measurement device 1, the external device 3 calculates a first power value on the basis of the received voltage values and current values. When the external device receives the voltage values and the current values of the input signals input to input terminal portions 2A and 2B from the measurement device 2, the external device calculates a second power value on the basis of the received voltage values and current values.

The external device 3 calculates the power efficiency of the measurement target on the basis of the calculated first power value and second power value. In the third embodiment, the external device 3 calculates the power efficiency of the power conversion device by dividing the second power value of power output from the output terminal portion of the power conversion device to be measured by the first power value of power input to the input terminal portion of the power conversion device.

In the third embodiment, the external device 3 receives the calculation results of the measurement devices 1 and 2 of the first embodiment and calculates the power value and the power efficiency on the basis of the calculation results; however, the present invention is not limited thereto. For example, the external device 3 may receive the calculation results of the respective channels of the measurement devices 1 and 2 of the second embodiment illustrated in FIG. 5 and calculate the power value and the power efficiency of each channel on the basis of the calculation results.

Operation and effects of the third embodiment are described below.

In the third embodiment, the measurement system 300 includes the external device 3 that communicates with the measurement device 1 and the measurement device 2. The external device 3 calculates power values on the basis of voltage values and current values calculated by the processor 10A functioning as a first calculator of the measurement device 1 and the processor 10B functioning as a second calculator of the measurement device 2.

According to this configuration, when the measurement device 1 measures input power of a measurement target and the measurement device 2 measures output power of the same measurement target, the relationship between the input and the output of the measurement target can be accurately ascertained.

In the third embodiment, the external device 3 calculates a first power value on the basis of the voltage value and the current value calculated by the processor 10A of the measurement device 1, and calculates a second power value on the basis of the voltage value and the current value calculated by the processor 10B of the measurement device 2. Subsequently, the external device 3 calculates power efficiency on the basis of the calculated first power value and second power value.

According to this configuration, all the measurement amounts used for calculating the power value are calculated at a measurement interval based on the same synchronization signal Ss1, so that a measurement error of the power efficiency can be reduced.

The first power value in the third embodiment is the input power of the power conversion device, and the second power value is the output power of the power conversion device. According to this configuration, since a measurement target is the power conversion device, the power efficiency of the power conversion device can be accurately measured.

Although each of the embodiments of the present invention has been described above, the embodiments merely illustrate a part of application examples of the present invention, and there is no intention to limit the technical scope of the present invention to the specific configurations of the embodiments described above.

For example, although the measurement device 2 is configured as one measurement device 2 in the above embodiments, the measurement device 2 may be configured as a plurality of measurement devices 2. In this case, the measurement amounts of a large number of channels can be accurately estimated compared to when one measurement device 2 is provided.

In the above embodiments, the input terminal portion and the output terminal portion of the measurement target such as the power conversion device are measured by the measurement devices 1 and 2; however, power transmitted at a measurement point in the middle of an input path or an output path of the measurement target may be measured.

In the above embodiments, the input terminal portions 1A, 1B, 2A, and 2B are each configured by positive and negative electrode terminals; however, when the measurement devices 1 and 2 are grounded, for example, the ground potential may be used as a reference potential and the input terminal portions 1A, 1B, 2A, and 2B may each be configured by only positive electrode terminals.

In the first embodiment, the measurement devices 1 and 2 are provided with a plurality of input terminal portions 1A/1B and 2A/2B, respectively; however, the number of input terminal portions of each of the measurement devices 1 and 2 may be one.

In addition, in the second embodiment, the measurement devices 1 and 2 are provided with four modules M1 to M4 and M5 to M8, respectively; however, the measurement devices 1 and 2 may be provided with two, three, or five or more modules, respectively.

In the second embodiment, the external device 3 is provided with the operation interface 30 for receiving an input operation of a user and the display unit 40; however, the operation interface 30 and the display unit 40 may be provided in the main body B1 of the measurement device 1 and the main body B2 of the measurement device 2.

This application claims priority based on Japanese Patent Application No. 2023-119933 filed to JPO on July 24, 2023, the entire contents of which are incorporated herein by reference.

### REFERENCE SIGNS LIST

100, 200 Measurement system
1, 2 Measurement device (first measurement device, second measurement device)
1A, 1B, 2A, 2B Input terminal portion (input terminal)
1C Output terminal
2C Synchronization terminal
10A Processor (detection unit, generation unit, first calculator, second calculator)
10B Processor (second calculator)
10C Processor (first calculator, second calculator)
14 Feature point detection unit (detection unit, generation unit)
16 Calculator (first calculator, second calculator)
Ss1 Synchronization signal
S2, S3, S4, S5 (generation step, output step, first calculation step)
S6 (reception step, second calculation step)

## Claims

1. A measurement system comprising a plurality of measurement devices that measure an input signal, wherein
a first measurement device comprises:
one or more input terminals for receiving the input signal;
a detection unit configured to detect a feature point of a wavelength of the input signal input to the input terminal;
a generation unit configured to generate a synchronization signal for synchronizing operations of the measurement devices on the basis of a timing at which the feature point is detected by the detection unit;
a first calculator configured to calculate a measurement amount of the input signal input to the one or more input terminals at a measurement interval determined by the synchronization signal; and
an output terminal for outputting the synchronization signal generated by the generation unit, and
one or more second measurement devices comprise:
one or more input terminals for receiving the input signal;
a synchronization terminal for receiving the synchronization signal output from the output terminal of the first measurement device; and
a second calculator configured to calculate a measurement amount of the input signal input to the one or more input terminals at the measurement interval determined by the synchronization signal.

2. The measurement system according to claim 1, wherein the input signal is a voltage signal or a current signal, and
the measurement amount is an effective value or an average value of the voltage signal or the current signal.

3. The measurement system according to claim 1, wherein the input terminals are provided in each of the measurement devices and include a voltage input terminal for receiving a voltage signal and a current input terminal for receiving a current signal, and
each of the first calculator and the second calculator calculates a voltage value of the voltage signal and a current value of the current signal as the measurement amount at the same measurement interval.

4. The measurement system according to claim 3, wherein each of the first calculator and the second calculator calculates a power value on the basis of the calculated voltage value and current value.

5. The measurement system according to claim 4, wherein the first calculator calculates a first power value on the basis of the calculated voltage value and current value,
the second calculator calculates a second power value on the basis of the calculated voltage value and current value, and
the first calculator or the second calculator calculates power efficiency on the basis of the first power value and the second power value.

6. The measurement system according to claim 3, further comprising:
an external device configured to communicate with the first measurement device and the second measurement device,
wherein the external device calculates a power value on the basis of the voltage value and the current value calculated by each of the first calculator and the second calculator.

7. The measurement system according to claim 6, wherein the external device calculates a first power value on the basis of the voltage value and the current value calculated by the first calculator,
calculates a second power value on the basis of the voltage value and the current value calculated by the second calculator, and
calculates power efficiency on the basis of the first power value and the second power value.

8. The measurement system according to claim 5 or 7, wherein one of the first power value and the second power value is input power of a power conversion device or power transmitted to an input path of the power conversion device, and
the other of the first power value and the second power value is output power of the power conversion device or power transmitted to an output path of the power conversion device.

9. A first measurement device connected to a second measurement device configured to calculate a measurement amount of an input signal input to one or more input terminals at a measurement interval determined by a synchronization signal for synchronizing operations of a plurality of measurement devices, the first measurement device comprising:
one or more input terminals for receiving an input signal different from the input signal;
a detection unit configured to detect a feature point of a wavelength of the input signal input to the input terminal;
a generation unit configured to generate the synchronization signal on the basis of a timing at which the feature point is detected by the detection unit;
a first calculator configured to calculate a measurement amount of the input signal input to the one or more input terminals at the measurement interval determined by the synchronization signal; and
an output terminal for outputting the synchronization signal generated by the generation unit to the second measurement device.

10. A second measurement device connected to a first measurement device that includes a first calculator configured to calculate a measurement amount of an input signal input to one or more input terminals at a measurement interval determined by a synchronization signal for synchronizing operations of a plurality of measurement devices, detects a feature point of a wavelength of the input signal input to the input terminal, and generates the synchronization signal on the basis of a detected timing, the second measurement device comprising:
one or more input terminals for receiving an input signal different from the input signal;
a synchronization terminal for receiving the synchronization signal output from the first measurement device; and
a second calculator configured to calculate a measurement amount of the input signal input to the one or more input terminals at the measurement interval determined by the synchronization signal.

11. A measurement method performed by a plurality of measurement devices that measure one or more input signals, the measurement method comprising:
a generation step of generating a synchronization signal for synchronizing operations of the measurement devices on the basis of a timing at which a feature point of a wavelength of the input signal input to a first measurement device is detected;
a first calculation step of calculating a measurement amount of the one or more input signals input to the first measurement device at a measurement interval determined by the synchronization signal;
an output step of outputting the synchronization signal;
a reception step of receiving the synchronization signal output from the first measurement device to at least one second measurement device; and
a second calculation step of calculating a measurement amount of the one or more input signals input to the at least one second measurement device at the measurement interval determined by the synchronization signal.
